(19) Europäisches Patentamt
European Patent Office
Office européen des brevets

(11) EP 0 511 698 B1

(12) FASCICULE DE BREVET EUROPEEN

(45) Date de publication et mention de la délivrance du brevet:
**08.07.1998 Bulletin 1998/28**

(51) Int Cl.[6]: **H04L 25/03**

(21) Numéro de dépôt: **92201048.3**

(22) Date de dépôt: **14.04.1992**

# (54) Egaliseur adaptatif semi-récursif

Halbrekursiver adaptiver Entzerrer

Semi-recursive adaptive equalizer

(84) Etats contractants désignés:
**DE FR GB IT**

(30) Priorité: **23.04.1991 FR 9104987**

(43) Date de publication de la demande:
**04.11.1992 Bulletin 1992/45**

(73) Titulaires:
- **LABORATOIRES D'ELECTRONIQUE PHILIPS S.A.S.**
  **94450 Limeil-Brévannes (FR)**
  Etats contractants désignés:
  **FR**
- **Philips Electronics N.V.**
  **5621 BA Eindhoven (NL)**
  Etats contractants désignés:
  **DE GB IT**

(72) Inventeurs:
- **Leverington, Mark, Société Civile S.P.I.D.**
  **F-75008 Paris (FR)**
- **Hayet, Pascal, Société Civile S.P.I.D.**
  **F-75008 Paris (FR)**
- **Finco, Eric, Société Civile S.P.I.D.**
  **F-75008 Paris (FR)**

(74) Mandataire: **Landousy, Christian et al**
**Société Civile S.P.I.D.**
**156, Boulevard Haussmann**
**75008 Paris (FR)**

(56) Documents cités:
**EP-A- 0 347 394** **FR-A- 2 554 996**

- **PATENT ABSTRACTS OF JAPAN vol. 5, no. 23 (E-45)(695) 12 February 1981 & JP-A-55 149 524**
- **KUNT 'Traitement numérique des signaux' 1981 , DUNOD , MONTROUGE, FR**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 511 698 B1

Printed by Jouve, 75001 PARIS (FR)

## Description

L'invention concerne un égaliseur adaptatif, opérant une égalisation de signaux numériques d'entrée transmis par un canal, comprenant une combinaison d'au moins un sommateur et d'un filtre linéaire numérique B commandé par une horloge de période T, le filtre B étant muni de cellules de retard et de cellules de calcul qui appliquent des coefficients de pondération.

L'égaliseur peut être utilisé pour corriger des distorsions produites par un canal au cours de la transmission de signaux. Il peut s'agir d'un annuleur d'échos. La transmission peut être réalisée par voie aérienne ou par câble.

L'invention peut concerner des signaux de type télévision ou des signaux numériques codés ou non codés.

La possibilité de trajets multiples dans la transmission hertzienne d'un signal conduit à la génération d'échos. Or, entre un écho et le signal original, il peut apparaître des retards de durées courtes ou longues (pouvant atteindre 10 microsecondes) avec des échos courts et/ou longs. Des situations analogues se présentent pour des transmissions numériques, par exemple les faisceaux hertziens.

Pour opérer une égalisation des signaux dans de telles situations, on connaît un annuleur d'échos décrit dans le document Patent Abstracts of Japan vol. 5, n° 23, 12 Février 1981. Il s'agit d'un système d'égalisation qui améliore la stabilité de fonctionnement et les performances d'égalisation en combinant un premier filtre de type direct et un second filtre qui peut commuter entre un fonctionnement de type direct et un fonctionnement de type récursif à l'aide d'un commutateur. Ce second filtre est associé à un élément de retard afin que ce second filtre corrige des échos ayant des retards longs. Du fait de la commutation, il y a un passage brusque entre les deux modes de fonctionnement du filtre. Or un même filtre avec les mêmes coefficients ne peut conserver des performances identiques lorsqu'il opère successivement en fonctionnement de type direct et en fonctionnement de type récursif. En effet, pour une longueur donnée de filtre, un filtre linéaire récursif opère un meilleur filtrage qu'un filtre linéaire direct. Mais un filtre récursif peut dans certaines conditions devenir instable ce qui n'est pas le cas d'un filtre linéaire direct. Réciproquement les filtres récursifs présentent intrinsèquement l'intérêt de nécessiter moins de coefficients, donc moins de multiplieurs, et aussi moins de cellules de retard pour obtenir des performances analogues de filtrage. Ils sont donc beaucoup plus compacts et donc moins onéreux.

Selon le document cité, il y a donc dégradation brusque des performances lorsqu'une situation de commutation ayant été détectée, le commutateur bascule le filtre dans un fonctionnement de type direct. Si par exemple des signaux issus d'images de télévision sont ainsi traités, il y a apparition d'images de qualité médiocre. Il est donc souhaitable de mieux maîtriser le fonctionnement d'un tel annuleur d'échos. En effet, dans les conditions variées où ces filtres sont destinés à être utilisés, la qualité du filtrage doit rester excellente. C'est notamment le cas de l'égalisation de signaux de télévision transmis par voie hertzienne. Toute situation instable est donc à éviter même temporairement.

On connaît également le document EP-A-0347394 qui décrit des filtrages FIR et IIR juxtaposés. En effet, il comporte un filtre FIR (11) et plusieurs filtres IIR (13, 14, 15, 16). Les moyens matériels sont distincts pour chaque filtre ainsi que les jeux de coefficients de pondération. Dans cet exemple, il y a 5 jeux différents de coefficients de pondération. Il s'agit donc d'une structure complexe présentant un coût élevé.

Le but de l'invention est de définir un égaliseur adaptatif qui présente de meilleures performances que les égaliseurs connus. En particulier les performances ne doivent pas être brusquement modifiées, ce qui peut être mal supporté notamment dans la perception des images. L'égaliseur doit disposer d'une bonne stabilité, et posséder une complexité réduite. Il doit pouvoir restituer des signaux égalisés, même imparfaitement dans de multiples situations d'utilisation. Cette amélioration des performances s'évalue pour une longueur donnée de filtre c'est-à-dire avec un même nombre de coefficients.

Ce but est atteint en faisant que l'égaliseur adaptatif comprend des moyens de commande qui mettent en oeuvre un coefficient de partage a pour faire fonctionner le filtre B en mode partagé, le filtre B ayant un fonctionnement partiellement de type direct et un fonctionnement partiellement de type récursif.

Ainsi selon l'invention, il est possible de disposer avantageusement des deux types de qualité (stabilité et qualité du filtrage) en faisant que le filtre B soit un filtre semi-récursif qui opère simultanément avec un comportement de type récursif et un comportement de type direct. Il est possible de doser l'un des comportements par rapport à l'autre à l'aide du coefficient de partage. Ceci présente l'avantage de faire que le filtre, en fonctionnement récursif, approche mieux sa limite de stabilité. L'égaliseur ne subit pas de variations brusques de fonctionnement. On met ainsi à profit la qualité de filtrage du comportement de type récursif en évitant l'apparition d'instabilités.

Plus particulièrement, le sommateur additionne les signaux numériques d'entrée et des signaux numériques de sortie issus du filtre B, les moyens de commande délivrant au filtre B un signal formé de la somme :

- du signal numérique d'entrée, atténué par un coefficient $\alpha$,
- et du signal numérique issu du sommateur, atténué par un coefficient $1 - \alpha$.

L'intérêt de cette structure est d'autoriser un filtrage récursif jusqu'à sa limite de stabilité. Au-delà, le filtre devient

progressivement direct tout en conservant les mêmes coefficients de pondération.

Il est possible de déplacer temporellement l'action du filtre B en le plaçant en série avec un retardateur qui applique un retard r d'au moins une période T d'horloge aux signaux numériques du filtre B. La correction peut ainsi concerner des échos à retards plus grands.

Le retardateur peut être placé soit en entrée soit en sortie du filtre B.

Avantageusement le filtre B peut ainsi corriger des échos à retards longs par les deux mécanismes de fonctionnement. Néanmoins, lorsque le filtre B est connecté avec un retardateur et lorsque le canal présente des échos à retards compris entre o et r, il ne peut alors pas corriger lesdits échos. Il ne peut pas non plus corriger des échos précédant l'instant t = o (échos anticausaux). Pour compléter l'égalisation effectuée par le filtre B, on combine alors le filtre B avec un filtre linéaire numérique A du type direct qui corrige les échos à retards courts qui ne sont pas pris en compte par le filtre B.

Comme il n'est pas toujours possible de prévoir si les échos apparaîtront avec des retards courts ou des retards longs, pour traiter simultanément ces deux types d'échos, on utilise préférentiellement une combinaison du filtre A et du filtre B muni d'un retardateur. Il est possible de placer le filtre A soit avant soit après la boucle de filtrage incluant B.

Un tel égaliseur adaptatif peut être utilisé pour traiter des signaux reçus qui ont subi des distorsions lors de leur transmission par un canal. En particulier, les phénomènes d'échos sont très courants lors de la transmission par voie hertzienne de signaux de type télévision. L'égaliseur élimine les échos des signaux reçus. Mais les échos peuvent évoluer dans le temps. Pour permettre cette élimination, le filtre B dispose de coefficients adaptés qui doivent être mis à jour régulièrement pour suivre l'évolution du canal. Un égaliseur maître élimine les échos des signaux d'entrée et un égaliseur esclave détermine les coefficients optimaux, pour chaque nouvel état du canal, à l'aide de signaux de référence. Par intervalles, les coefficients calculés dans l'égaliseur esclave sont transférés à l'égaliseur maître.

Dans ce cas, et lorsque l'égaliseur est utilisé sans filtre A, l'égaliseur comprend :

- un égaliseur adaptatif maître tel que décrit précédemment,
- et un égaliseur adaptatif esclave comprenant :

  . un autre BB filtre numérique linéaire B connecté en fonctionnement direct identique à celui de l'égaliseur maître, l'égaliseur esclave étant muni de moyens pour adapter des coefficients dudit autre filtre BB en annulant des échos d'un signal de référence reçu, transmis par le canal, en le comparant à un signal de référence généré localement, les coefficients dudit autre filtre BB étant respectivement transférés, par intervalle, dans le filtre B de l'égaliseur maître, un estimateur de stabilité fournissant aux moyens de commande du filtre B de l'égaliseur adaptatif maître un signal de commande ($\alpha$) définissant le coefficient de partage pour un fonctionnement direct et/ou recursif dudit filtre B.

Lorsque l'égaliseur maître possède un filtre A, l'égaliseur esclave possède alors un autre AA filtre numérique linéaire A. Comme pour les filtres B et BB, les mêmes étapes de calcul et de transfert de coefficients sont effectuées pour les filtres A et AA.

Pour déterminer si les coefficients nouvellement déterminés peuvent être utilisés pour une mise à jour des coefficients de l'égaliseur maître, il faut estimer si une instabilité est prévisible en type récursif. Pour cela, un estimateur de stabilité détermine la somme du module de tous les coefficients. Ceci permet d'ajuster les atténuations ($1 - \alpha$) et a à appliquer aux signaux issus respectivement du trajet direct et de la boucle récursive.

Un tel égaliseur peut être utilisé pour traiter des signaux de télévision ayant la norme D2 - MAC. Le signal de référence, transmis par le canal, utilisé pour la mise à jour des coefficients peut alors être le signal duobinaire conforme à ladite norme. Le signal de référence généré localement est alors un signal duobinaire local.

Il est aussi possible que le signal de référence, transmis par le canal, utilisé pour la mise à jour des coefficients soit un signal de référence vidéo numérisé. La structure de ce signal étant connue, il est donc facile de générer localement un signal de référence conforme à celui émis par l'émetteur, avant la transmission. Ce signal de référence peut par exemple être formé d'échantillons numériques transmis sur une ligne d'une trame de télévision.

L'invention sera mieux comprise à l'aide des figures suivantes données à titre d'exemples non limitatifs qui représentent :

Figures 1A, 1B : deux schémas du filtre B connecté respectivement en fonctionnement direct et en fonctionnement récursif,

Figure 2 : un schéma d'un exemple préférentiel de réalisation d'un égaliseur maître selon l'invention,

Figure 3 : un schéma d'un autre égaliseur maître selon l'invention,

Figures 4, 5 : deux schémas de deux égaliseurs esclaves pour la détermination de coefficients mis à jour,

Figure 6 : un schéma d'un égaliseur comprenant un égaliseur maître et un égaliseur esclave opérant sur des signaux transmis par un canal.

La structure de l'égaliseur selon l'invention est fondée sur le fait qu'un filtre B fonctionnant en type récursif offre de meilleures performances de filtrage qu'un filtre linéaire B fonctionnant en type direct pour un même nombre de coefficients. Mais le fonctionnement de type récursif peut donner lieu à des instabilités. L'invention propose donc de faire opérer un filtre linéaire B en priorité en fonctionnement de type récursif dans la mesure où le fonctionnement ne devient pas instable. Lorsqu'une situation d'instabilité est estimée, le fonctionnement du filtre linéaire B peut être progressivement modifié entre un mode de type direct et un mode de type récursif.

La description qui va suivre concerne principalement le cas où l'égaliseur adaptatif possède un filtre A et un filtre B muni d'un retardateur (sauf situations contraires indiquées). Préférentiellement les filtres A et B possèdent un même nombre n de coefficients.

Pour égaliser des signaux présentant des échos courts et longs, le filtre B doit être mis en série avec un retardateur $z^{-n}$ (où n est le nombre de coefficients du filtre) retardant les signaux de n périodes d'horloge. Pour que l'égaliseur ait un fonctionnement correct pour tous les types d'échos lorsque le filtre B est connecté en fonctionnement mixte direct/récursif, on place en série un filtre linéaire A. De cette manière, l'égaliseur peut fonctionner soit totalement en direct soit partiellement en direct et partiellement en récursif grâce au filtre linéaire A fonctionnant en direct et au filtre linéaire B fonctionnant en direct et/ou en récursif.

La fonction de transfert du filtre linéaire A est :

$$G\ (z) = \sum_{i=1}^{n} g_i . z^{-i}$$

et celle du filtre linéaire B est :

$$H(z) = \sum_{i=1}^{n} h_i . z^{-i}$$

Il y a lieu de discerner les types d'échos qui apparaissent dans le canal. On définit des échos dits courts ayant des retards situés entre o et nT (où T est la période d'échantillonnage et où n est la longueur du filtre) et des échos dits longs ayant des retards situés entre (n+1)T et 2nT.

Le mécanisme d'égalisation du canal sera alors différent selon que le filtre B a un fonctionnement direct ou récursif.

L'invention concerne en particulier la correction de ces échos longs (entre (n+1)T et 2nT). Ceux-ci ne peuvent, en effet, pas être corrigés par un unique filtre connecté en direct (pour une longueur n donnée du filtre). Subsidiairement elle concerne également la correction des échos courts et longs.

Dans le cas général, on considère un canal qui présente à la fois des échos courts et longs. La fonction de transfert du canal s'écrit :

$$1 - \sum_{i=1}^{2n} e_i . z^{-i}$$

Si on considère un égaliseur selon la figure 1A pour lequel le filtre linéaire B est connecté en fonctionnement direct, la fonction de transfert global E(z) s'écrit :

$$E(z) = (1-\sum_{i=1}^{2n} e_i . z^{-i})\ (1+\sum_{i=1}^{n} h_i . z^{-i})$$

C'est-à-dire :

$$E(z) = 1 + \underbrace{\sum_{i=1}^{n} (h_i - e_i)\ z^{-i}}_{P} - \underbrace{\sum_{i=n+1}^{2n} e_i . z^{-i} - \sum_{i=1}^{2n} e_i . z^{-i} \sum_{i=1}^{n} h_i . z^{-i}}_{Q}$$

Le terme P se rapporte aux échos courts. Le terme Q se rapporte aux échos longs. Le premier terme de Q indique une absence d'égalisation entre (n+1)T et 2nT. Le second terme de Q indique une imperfection d'égalisation entre 1T et 2nT.

Si les coefficients $h_i$ sont déterminés pour que $h_i = e_i$ le terme P s'annule mais le terme Q ne s'annule généralement pas. Le filtre linéaire B ainsi connecté ne corrige donc pas le terme Q.

Il est également possible de déterminer les coefficients $h_i$ pour minimiser à la fois le terme P et le terme Q. Mais dans ce cas $h_i$ est généralement différent de $e_i$ et le terme P n'est qu'imparfaitement corrigé.

Selon l'invention on préfère favoriser la correction du terme P et déplacer le terme Q hors des limites temporelles de correction du filtre.

Pour cela on dispose le filtre B en série avec un retardateur $z^{-n}$.

La fonction de transfert global E(z) devient :

$$E(z) = (1 - \sum_{i=1}^{2n} e_i . z^{-i})\ (1 + z^{-n} . \sum_{i=1}^{n} h_i . z^{-i})$$

En développant cette équation peut aussi s'écrire :

$$E(z) = 1 - \sum_{i=1}^{n} e_i . z^{-i} +$$

$$\underbrace{z^{-n} \sum (h_i - e_{i+n}) . z^{-i}}_{P'} - \underbrace{z^{-n} \sum_{i=1}^{n} h_i . z^{-i} \sum_{i=1}^{2n} e_i . z^{-i}}_{Q'}$$

On se limite alors à déterminer les coefficients $h_i$ pour que $h_i = e_{i+n}$ en acceptant une égalisation imparfaite du terme Q' qu'il n'est pas possible d'éliminer complètement.

Le terme

$$\sum_{i=}^{n} e_i . z^{-i}$$

se rapporte aux échos de durée courte qui apparaissent dans la fonction de transfert du canal. Deux situations peuvent alors se présenter :

- soit que ce terme est nul car il n'y a pas d'échos, donc pas d'énergie entre les instants o et nT, et le filtre B en série avec le retardeur suffit à égaliser imparfaitement le canal comme cela vient d'être décrit,
- soit que ce terme n'est pas nul ce qui nécessite de placer en supplément un filtre A connecté en direct pour égaliser ces échos de durée courte du canal.

Lorsque le filtre linéaire B est connecté en fonctionnement récursif selon la figure 1 B, la fonction de transfert E (z) devient :

$$E(z) = (1-\sum_{i=1}^{2n} e_i . z^{-i}) \ / \ (1-z^{-n}.\sum_{i=1}^{n} h_i . z^{-i})$$

C'est-à-dire :

$$E(z) = \underbrace{(1-z^{-n}\sum_{1}^{n} e_{i+n}.z^{-i}) \ / \ (1-z^{-n}\sum_{1}^{n} h_i.z^{-i})}_{P''} - \underbrace{(\sum_{1}^{n} e_i.z^{-i}) \ / \ (1-z^{-n}\sum_{1}^{n} h_i.z^{-i})}_{Q''}$$

On vérifie que le terme P" est éliminé totalement lorsque $h_i = e_{i+n}$.

Le terme Q" se rapporte aux échos de durée courte qui apparaissent dans la fonction de transfert du canal. Deux situations peuvent se présenter :

- soit que ce terme est nul car il n'y a pas d'échos, donc pas d'énergie entre les instants o et nT, et le filtre B en série avec le retardeur suffit à égaliser parfaitement le canal comme cela vient d'être décrit,
- soit que ce terme n'est pas nul ce qui nécessite de placer en supplément un filtre A connecté en direct pour égaliser ces échos de durée courte du canal.

Pour corriger les échos de durée longue, on obtient ainsi une égalisation parfaite en fonctionnement récursif et une égalisation satisfaisante mais imparfaite en fonctionnement direct.

En appelant $n_2$ le nombre de retards imposés par le retardateur ($z^{-n2}$), on observe dans les deux cas que le filtre linéaire B ne peut pas corriger des retards courts c'est-à-dire ceux dont la fonction de transfert est :

$$\sum_{i=1}^{n2} e_i . z^{-i}$$

Pour que ces retards courts puissent aussi être corrigés, la dimension du filtre linéaire A doit être au moins égale à $n_2$, et être supérieure ou égale à la dimension n du filtre linéaire B.

En appelant

$n_1$ la dimension du filtre B
$n_2$ la dimension du retardateur
$n_3$ la dimension du filtre A

on doit avoir :

$n_2 \geq n_1$, $n_3 \geq n_1$ et $n_3 \leq n_2$

Préférentiellement on donne au filtre linéaire A la même dimension n que celle du filtre linéaire B afin que le fonctionnement récursif du filtre B soit le plus actif. On donne également au retardateur la même dimension n.

ESTIMATION D'INSTABILITE

Le filtre linéaire B opère avec les mêmes coefficients $h_i$, à la fois en fonctionnement direct et en fonctionnement récursif. Une situation d'instabilité du fonctionnement récursif sera estimée en calculant :

$$\sum_{i=1}^{n} |h_i|$$

On observe que :

. le filtre B est stable en fonctionnement récursif, lorsque :

$$\sum_{i=1}^{n} |h_i|<1$$

. le filtre B peut être instable en fonctionnement récursif, lorsque :

$$\sum_{i=1}^{n} |h_i|\geq 1$$

Cette dernière situation est à estimer préalablement afin de donner au filtre B un fonctionnement principalement ou exclusivement direct si une instabilité est prévisible.

Si on définit un taux $\alpha$ de fonctionnement en récursif et un taux (1 - $\alpha$) de fonctionnement en direct, les valeurs de $\alpha$ peuvent par exemple être définies par :

$$.\ \alpha = 1 \ lorsque \ \sum_{i=1}^{n} |h_i| \leq (1-\varepsilon)$$

$$.\ et \ \alpha = \frac{1-\varepsilon}{\sum_{i=1}^{n} |h_i|} \quad lorsque: \sum_{i=1}^{n} |h_i| > (1-\varepsilon)$$

où $\varepsilon$ est une quantité très faible par exemple $\varepsilon = 1/20$.

Il est également possible de déterminer les valeurs de $\alpha$ par des essais de valeurs successives et de choisir celle qui fournit des résultats optimaux. Un ou des coefficients de partage peuvent être prédéterminés pour un type de canal donné, et être stockés dans une mémoire, par exemple une mémoire PROM, puis chargés dans l'égaliseur en fonction des conditions de transmission.

PREMIER EXEMPLE DE REALISATION

La figure 2 représente un schéma d'un exemple préférentiel de réalisation d'un égaliseur 50, dit "égaliseur maître". Un sommateur 10 reçoit les sorties SSA et SSB d'un filtre linéaire numérique A et d'un filtre linéaire numérique B ayant chacun n coefficients. Le filtre B est précédé d'un retardateur 12 qui retarde de n durées d'horloge T des signaux SEB placés en entrée. Les filtres A et B et le retardateur 12 sont commandés par l'horloge de période T. Les données d'entrée SE entrent dans le filtre A. Les signaux SEB sont délivrés par des moyens 13 de commande qui additionnent une partie $\alpha$ du signal de sortie SS du sommateur avec une partie (1 - $\alpha$) du signal de sortie SSA du filtre A. Pour cela les moyens de commande comprennent :

- un premier 18 multiplieur qui délivre un signal $\alpha$. SS
- un second 17 multiplieur qui délivre un signal (1-$\alpha$).SSA
- un autre sommateur 19 qui additionne $\alpha$.SS + (1-$\alpha$).SSA = SEB.

Ainsi le filtre B associé au retardateur 12 présente selon la boucle 15 un fonctionnement partiellement de type direct et selon la boucle 16 un fonctionnement partiellement de type récursif. La valeur de $\alpha$ permet de doser la répartition entre les deux types de fonctionnement. Les coefficients respectifs des filtres A et B sont régulièrement mis à jour par les connexions CA et CB respectivement.

Il est possible de placer le retardateur 12 entre le filtre B et le sommateur 10. De même il est possible de placer le filtre A après le point P commun au sommateur 10 et aux moyens de commande 13. Les données d'entrée SE entrent alors directement sur le sommateur 10 et le multiplieur 17.

DEUXIEME EXEMPLE DE REALISATION

La figure 3 représente un schéma d'un autre égaliseur 50 dit "égaliseur maître" selon l'invention. Les mêmes éléments sont munis des mêmes repères. La différence consiste à n'utiliser qu'un seul multiplieur 18 au lieu de deux multiplieurs. Le signal qui entre dans le multiplieur 18 est alors prélevé à la sortie du filtre B (signal SSB). Le sommateur 19 est connecté directement par une de ses entrées à la sortie du filtre A.

ADAPTATION

La figure 4 est un schéma d'un égaliseur dit "égaliseur esclave" 52 qui permet d'effectuer la détermination des coefficients des filtres adaptés à un instant à une égalisation correcte du canal de transmission. Pour cela, il comprend :

- un autre AA filtre linéaire numérique identique au filtre A,
- un autre BB filtre linéaire numérique identique au filtre B, connecté en fonctionnement direct,
- un autre retardeur 22.

Un signal de référence reçu SREC entre dans le filtre AA. Un signal de référence local SREF entre dans le montage série du retardateur 22 et du filtre BB. Le signal de référence local SREF est le signal auquel doit être comparé le signal de référence reçu SREC transmis par le canal, donc muni de distorsions. Un sommateur 20 additionne les signaux de sortie des filtres AA et BB et délivre un signal composé CREF. Celui-ci est soustrait du signal de référence local SREF dans le soustracteur 21 qui délivre un signal d'erreur err. Celui-ci est introduit dans un module 23 qui calcule les nouveaux coefficients des filtres A et B nécessaires à cet instant pour égaliser le canal. Pour cela, le module 23 met en oeuvre par exemple la méthode connue du gradient stochastique de l'erreur quadratique moyenne. Elle est décrite par exemple dans le brevet EP 0146979.

En appelant { $r_k$ } des échantillons du signal de référence local, et { $y_k$ } des échantillons d'un signal analogue transmis par le canal, le signal d'erreur err s'écrit pour l'ordre k :

$$err_k = \sum_{i=1}^{n} g_i \cdot y^{k-i} + \sum_{i=n+1}^{2n} h_i \cdot r^{k-i} - r_k$$

L'algorithme du gradient stochastique permet de calculer les coefficients nouveaux qui minimisent cette erreur $err_k$. Pour chaque étape d'ordre L, les coefficients des filtres AA et BB sont déterminés selon :

$$g_i^L = g_i^{L-1} - \delta e_k . Y_{k-i} \qquad 1 \leq i \leq +n$$

$$h_i^L = h_i^{L-1} - \delta e_k . R_{k-i} \qquad n+1 \leq i \leq 2n$$

où $\delta e_k$ est un pas d'adaptation.

Lorsque les coefficients des filtres AA et BB ont été déterminés, ils sont transmis (connexions CA et CB) aux filtres A et B de l'égaliseur maître.

Lorsque l'égaliseur opère sans l'aide d'un égaliseur esclave, une procédure analogue d'adaptation est mise en oeuvre pour le filtre B à des moments où le filtre B est disponible, par exemple lors de la mise en marche de l'égaliseur. Il est aussi possible de charger dans l'égaliseur des coefficients prédéterminés stockés par exemple dans une mémoire PROM.

La figure 5 est un autre schéma d'un égaliseur esclave. Il comprend les mêmes éléments connectés différemment. C'est dans ce cas la sortie du filtre AA qui entre dans le montage en série du retardateur 22 et du filtre BB. Le sommateur

20 additionne les sorties des filtres AA et BB. Le filtre AA reçoit en entrée le signal de référence reçu SREC. Le signal de référence local SREF arrive sur une entrée du soustracteur 21 qui reçoit sur une autre entrée la sortie du sommateur 20. Le signal d'erreur err du soustracteur est utilisé de la même manière que précédemment. La détermination des nouveaux coefficients et leur mise à jour dans les filtres A et B s'opère comme cela a été décrit précédemment.

Les positions du filtre BB et du retardateur 22 peuvent être commutées.

Il est possible à l'homme du métier de déterminer différemment les valeurs des coefficients des filtres sans sortir du cadre de l'invention. De même l'égaliseur esclave peut être simplifié en n'utilisant pas de filtre AA lorsque le filtre A n'existe pas.

Un tel égaliseur peut être utilisé pour opérer avec des signaux de type télévision par exemple ayant la norme D2-MAC. L'égaliseur doit tout d'abord déterminer son fonctionnement optimal à l'aide de signaux de référence (reçu et local) puis opérer l'égalisation des signaux de télévision eux-mêmes.

La figure 6 représente le schéma d'un égaliseur comprenant un égaliseur maître 50 et un égaliseur esclave 52 ayant tous deux une structure analogue. Les signaux d'entrée SE entrent dans un module d'entrée 54 qui effectue un prétraitement portant sur la numérisation des signaux, un clamp, et un contrôle automatique de gain. Les signaux d'entrée SE prétraités sont introduits dans l'égaliseur maître 50 pour délivrer des signaux de sortie SS égalisés.

Pour permettre la mise à jour des coefficients, un circuit 56 détecte les signaux de référence SREC contenus dans les signaux d'entrée SE. Lors de la réception de signaux de référence SREC émis sur une ligne de référence d'une trame de télévision (voir ci-après), le circuit 56 active un générateur 58 qui génère un signal de référence local SREF. Lorsque le signal de référence est un signal duobinaire (voir ci-après) le signal de référence SREF est formé par le générateur 58 à partir du signal duobinaire égalisé, décodé par le décodeur 62. Les signaux SREC et SREF sont introduits dans l'égaliseur esclave 52 qui effectue la détermination des coefficients comme cela a été décrit précédemment. Un estimateur de stabilité 60 détermine ensuite la stabilité prévisible du filtre linéaire B en calculant la somme des nouveaux coefficients $h_i$. L'estimateur de stabilité 60 délivre alors un signal représentant le coefficient $\alpha$. Les nouveaux coefficients $g_i$ et $h_i$ sont transmis à l'égaliseur maître par les connexions CA et CB.

Le choix du signal de référence doit être guidé par ses caractéristiques spectrales et être le plus décorrelé possible (ce qui correspond à une densité spectrale de puissance constante sur tout le spectre de fréquences). Pour satisfaire en partie ces conditions, il est possible d'utiliser un signal de données numériques codé en duobinaire émis en conformité avec la norme D2-MAC. Le code duobinaire est obtenu par addition arithmétique d'un signal binaire à coder avec lui-même retardé d'un cycle d'horloge. Il réalise un filtrage en cosinus surélevé qui limite le spectre à la demi fréquence d'horloge. L'absence d'énergie au-delà de 5 MHz ne permet pas l'égalisation du canal dans cette région. Cet inconvénient ne nuit pas à l'égalisattion du signal duobinaire proprement dit mais il limite les performances vis-à-vis du signal vidéo (résidus haute fréquence). Le signal D2-MAC comporte 208 échantillons duobinaires par ligne. Dans le cas d'un filtre égaliseur comportant 50 coefficients, on peut disposer d'environ 150 itérations/ligne. La convergence (plus de 1500 itérations) est donc largement assurée sur l'image (40 ms). Un décodeur duobinaire 62 est alors utilisé pour récupérer le signal binaire lui-même. Pour générer localement le signal duobinaire de référence SREF, le générateur 58 (figure 6) est alors un codeur duobinaire qui recode en duobinaire le signal binaire décodé par le décodeur 62.

Une autre possibilité consiste à utiliser une ligne spéciale d'une trame de télévision pour transmettre un signal de référence de structure connue. Ainsi la ligne 624 réservée à un signal de wobulation défini par 512 échantillons peut être utilisée à cet effet. Un tel signal de référence de même dynamique que la composante vidéo est composé d'une partie réelle transmise sur les images paires et d'une partie imaginaire transmise sur les images impaires. Chacune de ces composantes fournit indifféremment un signal de référence idéal pour l'égalisation. On dispose en effet d'un signal dont l'énergie s'étend sur tout le spectre, qui permet plus de 256 itérations par image (convergence en 80 à 120 ms).

**Revendications**

1. Egaliseur adaptatif, opérant une égalisation de signaux numériques d'entrée transmis par un canal, comprenant une combinaison d'au moins un sommateur (10) et d'un filtre linéaire numérique B commandé par une horloge de période T, le filtre B étant muni de cellules de retard et de cellules de calcul qui appliquent des coefficients de pondération, caractérisé en ce qu'il comprend des moyens de commande (13) qui mettent en oeuvre un coefficient de partage a pour faire fonctionner le filtre B en mode partagé, le filtre B ayant simultanément un fonctionnement partiellement de type direct et un fonctionnement partiellement de type récursif.

2. Egaliseur selon la revendication 1 caractérisé en ce que le sommateur (10) additionne les signaux numériques d'entrée et des signaux numériques de sortie issus du filtre B, les moyens de commande (13) délivrant au filtre B un signal formé de la somme :

- . du signal numérique d'entrée atténué par un coefficient 1 - α,
- . et du signal numérique issu du sommateur, atténué par le coefficient de partage α.

**3.** Egaliseur selon la revendication 2 caractérisé en ce que les moyens de commande (13) comprennent :

- un premier multiplieur (18) qui délivre ledit signal atténué d'un coefficient α,
- un second multiplieur (17) qui délivre ledit signal numérique atténué d'un coefficient (1 -α),
- un autre sommateur (19) qui additionne les deux signaux numériques délivrés par les deux multiplieurs.

**4.** Egaliseur selon une des revendications 1 à 3 caractérisé en ce qu'il comprend un retardateur (12), monté en série avec le filtre B, appliquant un retard d'au moins une période T d'horloge aux signaux numériques du filtre B.

**5.** Egaliseur selon la revendication 4 caractérisé en ce que le retardateur (12) est placé soit en entrée soit en sortie du filtre B.

**6.** Egaliseur selon une des revendications 4 ou 5 caractérisé en ce qu'il comprend une combinaison dudit filtre B et d'un filtre linéaire numérique A de type direct qui corrige des échos à retards courts du canal, ledit filtre A étant placé soit en entrée soit en sortie de la combinaison comprenant par ledit filtre B, le sommateur (10) et les moyens de commande (13), le retard appliqué par le retardateur étant supérieur ou égal à celui appliqué par le filtre A.

**7.** Egaliseur selon la revendication 1 caractérisé en ce qu'il comporte en outre un égaliseur adaptatif esclave (52) comprenant :

- un second filtre numérique linéaire (BB) connecté en fonctionnement direct,
- des moyens (21, 23) pour adapter des coefficients dudit second filtre en annulant des échos d'un signal de référence reçu en le comparant à un signal de référence généré localement,
- un estimateur de stabilité (60) du second filtre fournissant aux moyens de commande (13) un signal de commande définissant le coefficient de partage α,

les coefficients du second filtre étant transférés, par intervalle, dans le filtre (B) lorsque la stabilité est assurée.

**8.** Egaliseur selon la revendication 7 caractérisé en ce qu'il opère sur des signaux ayant une norme D2 - MAC transmis par le canal, le signal de référence reçu étant le signal duobinaire conforme à ladite norme, le signal de référence généré localement étant obtenu en décodant le signal duobinaire reçu puis en le recodant en duobinaire.

**9.** Egaliseur selon la revendication 7 caractérisé en ce qu'il opère sur des signaux ayant une norme D2 - MAC, le signal de référence reçu étant un signal de référence vidéo numérisé transmis par le canal.

## Patentansprüche

**1.** Adaptiver Entzerrer, der eine Entzerrung über einen Kanal übertragener digitaler Eingangssignale durchführt, der eine Verbindung von mindestens einem Summierer (10) und einem linearen digitalen Filter B enthält, gesteuert über einen Taktgeber T, wobei der Filter B mit Verzögerungszellen und Berechnungszellen versehen ist, die Ponderationskoeffizienten anwenden, dadurch gekennzeichnet, daß er mit Steuermitteln (13) versehen wird, die einen Teilungskoeffizienten α verwenden, um den Filter B in geteiltem Modus arbeiten zu lassen, wobei der Filter B simultan eine Teil-Funktionsweise des direkten Typs und eine Teil-Funktionsweise des rekursiven Typs hat.

**2.** Entzerrer nach Anspruch 1, dadurch gekennzeichnet, daß der Summierer (10) die digitalen Eingangssignale und die aus dem Filter B herrührenden digitalen Ausgangssignale addiert, während die Steuermittel (13) ein aus der Summe gebildetes Signal an den Filter B abgeben :

- . und ein aus dem Summierer herrührenden digitalen Signals, abgeschwächt durch einen Koeffizienten 1 - α,
- . des digitalen Eingangssignals, abgeschwächt durch einen Koeffizienten α.

**3.** Entzerrer nach Anspruch 2, dadurch gekennzeichnet, daß die Steuermittel (13) enthalten :

- einen ersten Multiplikator (18), der das besagte, um einen Koeffizienten α geschwächte Signal abgibt,

- einen zweiten Multiplikator (17), der das besagte, um einen Koeffizienten (1-α) geschwächte digitale Signal abgibt,
- einen anderen Summierer (19), der die beiden, von den zwei Multiplikatoren gelieferten digitalen Signale addiert.

4. Entzerrer nach einem der Ansprüche 1 bis 3, dadurch gekennzeichnet, daß er einen Verzögerer (12) enthält, in Serie mit dem Filter B geschaltet, der eine Verzögerung von mindestens einem Zeittakt T auf die digitalen Signale des Filters B anwendet.

5. Entzerrer nach Anspruch 4, dadurch gekennzeichnet, daß der Verzögerer (12) entweder am Eingang oder am Ausgang des Filters B vorgesehen wird.

6. Entzerrer nach einem der Ansprüche 4 oder 5, dadurch gekennzeichnet, daß er eine Verbindung aus dem besagten Filter B und einem digitalen linearen Filter A direkten Typs enthält, der die Echos kurzer Verzögerung des Kanals korrigiert, der besagte Filter A wird entweder am Eingang oder am Ausgang der Verbindung aus dem besagten Filter B, dem Summierer (10) und den Steuermitteln (13) vorgesehen, wobei die vom Verzögerer bewirkte Verzögerung entweder größer oder gleich der vom Filter A bewirkten ist.

7. Entzerrer nach Anspruch 1, dadurch gekennzeichnet, daß er außerdem einen adaptiven Nebenentzerrer (52) enthält, bestehend aus :

- einem zweiten linearen digitalen Filter (BB), angeschlossen in direkter Funktionsweise,
- Mitteln (21, 23), um die Koeffizienten des besagten zweiten Filters anzupassen, durch Auslöschung der Echos eines empfangenen Referenzsignals, indem es mit einem lokal erzeugten Referenzsignal verglichen wird,
- einem Stabilitätsbewerter (60) des zweiten Filters, der den Steuermitteln (13) ein Steuersignal zur Definition des Teilungskoeffizienten α liefert,

die Koeffizienten des zweiten Filters werden in Intervallen in den Filter (B) übertragen, wenn die Stabilität gewährt ist.

8. Entzerrer nach Anspruch 7, dadurch gekennzeichnet, daß er über den Kanal übertragene Signale entsprechend der Norm D2-MAC bearbeitet, das empfangene Referenzsignal ist das der Norm entsprechende duobinäre Signal, während das lokal erzeugte Referenzsignal durch Dekodierung des duobinären Signals und anschließender duobinärer Neukodierung erhalten wird.

9. Entzerrer nach Anspruch 7, dadurch gekennzeichnet, daß er Signale entsprechend der Norm D2-MAC bearbeitet, während das empfangene Referenzsignal ein über den Kanal übertragenes digitales Videoreferenzsignal ist.

**Claims**

1. Adaptive equalizer which performs an equalization of digital input signals transmitted by a channel, comprising a combination of at least a summator (10) and a digital linear filter B controlled by a clock of period T, the filter B comprising delay cells and calculation cells which apply weighting factors, characterized in that the adaptive equalizer comprises control means (13) which use a splitting factor α for permitting the filter B to operate in a splitting mode, the filter B simultaneously having a partly direct and partly a recursive type of operation.

2. Equalizer as claimed in Claim 1, characterized in that the summator (10) adds together the digital input signals and digital output signals coming from filter B, whilst the control means (13) supply to the filter B a signal formed by the sum of:

. the digital input signal attenuated by a factor 1-α,
. and the digital signal coming from the summator, attenuated by the splitting factor α.

3. Equalizer as claimed in Claim 2, characterized in that the control means (13) comprise:

- a first multiplier (18) which supplies said signal attenuated by a factor α,
- a second multiplier (17) which supplies said digital signal attenuated by a factor (1-α),

- a further summator (19) which adds together the two digital signals supplied by the two multipliers.

4. Equalizer as claimed in one of the Claims 1 to 3, characterized in that it comprises a delay means (12) arranged in a series combination with the filter B, and applying a delay of at least one clock period T to the digital signals of filter B.

5. Equalizer as claimed in Claim 4, characterized in that the delay means (12) is arranged either at the input or output of the filter B.

6. Equalizer as claimed in one of the Claims 4 or 5, characterized in that it comprises a combination of said filter B and a digital linear filter A of the direct type which corrects short-delay channel echoes, said filter A being arranged either at the input or at the output of the combination formed by said filter B, the summator (10) and the control means (13), the delay applied by the delay means exceeding or being equal to that applied by the filter A.

7. Equalizer as claimed in Claim 1, characterized in that it also comprises a slave adaptive equalizer (52) comprising:

- a second (BB) digital linear filter connected in the direct mode,
- means (21, 23) for adapting coefficients of said second filter by cancelling echoes of a received reference signal comparing the received reference signal with a locally generated reference signal,
- a stability estimator (60) of the second filter supplying a control signal to the control means (13), which signal defines the splitting factor $\alpha$,
- the coefficients of said second filter being transferred at intervals in the filter (B) when the stability is assured.

8. Equalizer as claimed in Claim 7, characterized in that it influences signals of a D2-MAC standard transmitted by the channel, the received reference signal being the duobinary signal according to said standard, the locally generated reference signal being obtained by decoding the received duobinary signal and then recoding same into the duobinary mode.

9. Equalizer as claimed in Claim 7, characterized in that it influences signals of a D2-MAC standard, the received reference signal being a digitized video reference signal transmitted by the channel.

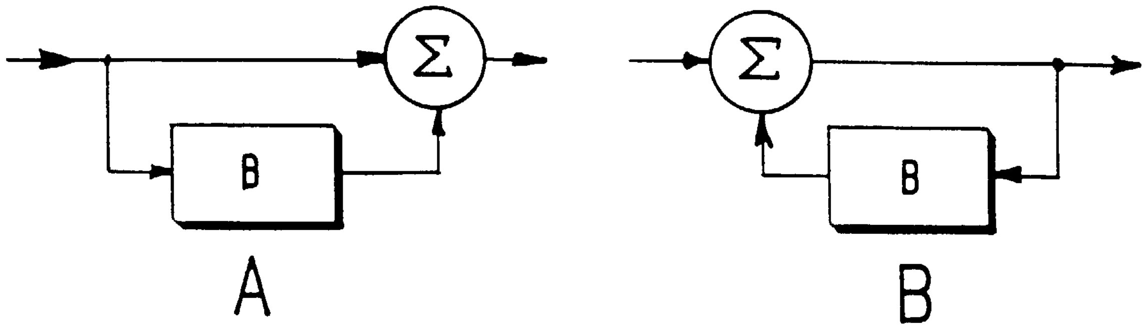
Σ
B
A
Σ
B
B

FIG.1

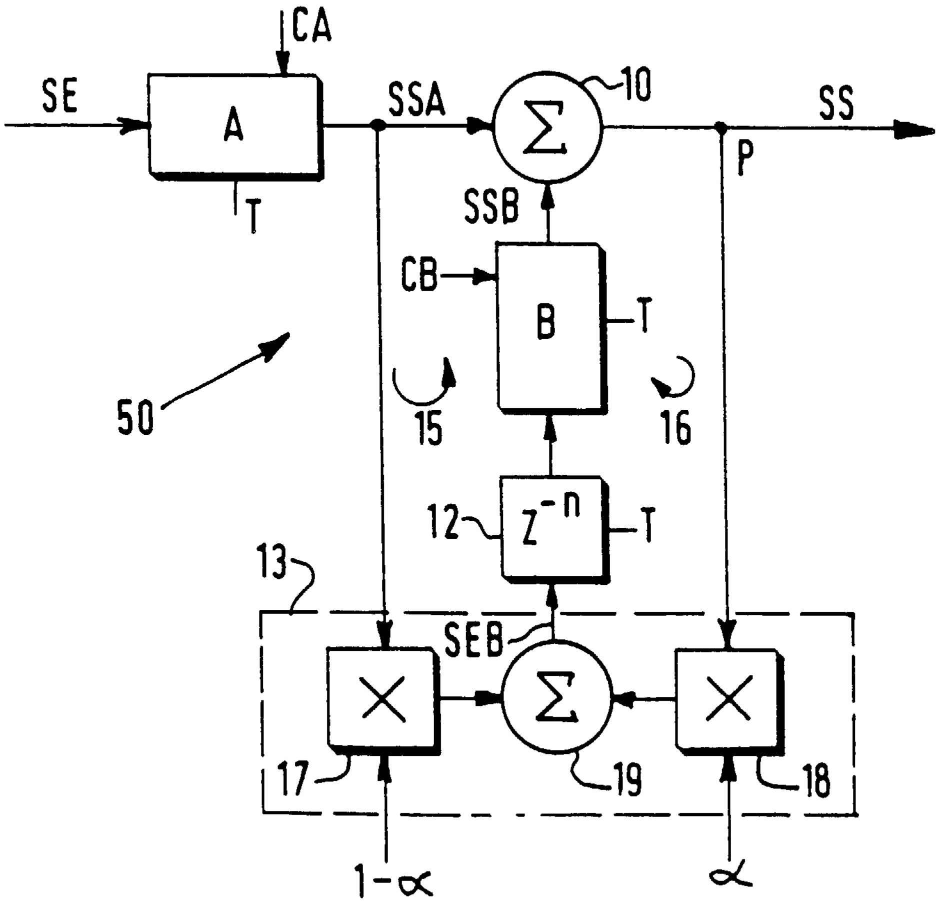
CA
SE
A
SSA
Σ
10
SS
P
T
SSB
CB
B
T
50
15
16
12
Z^-n
T
13
SEB
×
Σ
×
17
19
18
1-α
α

FIG.2

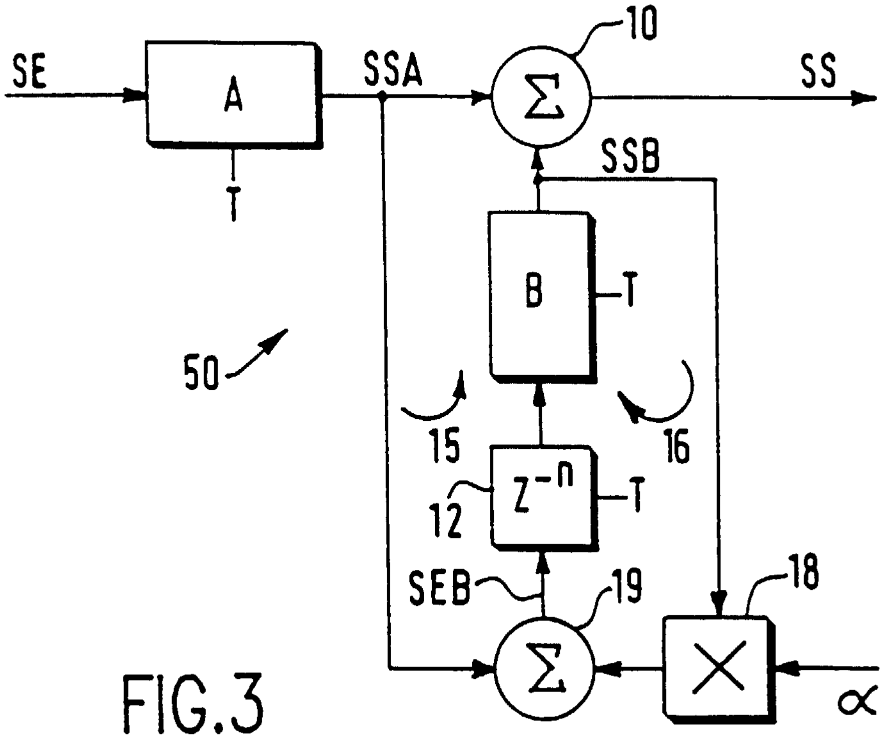


FIG.3

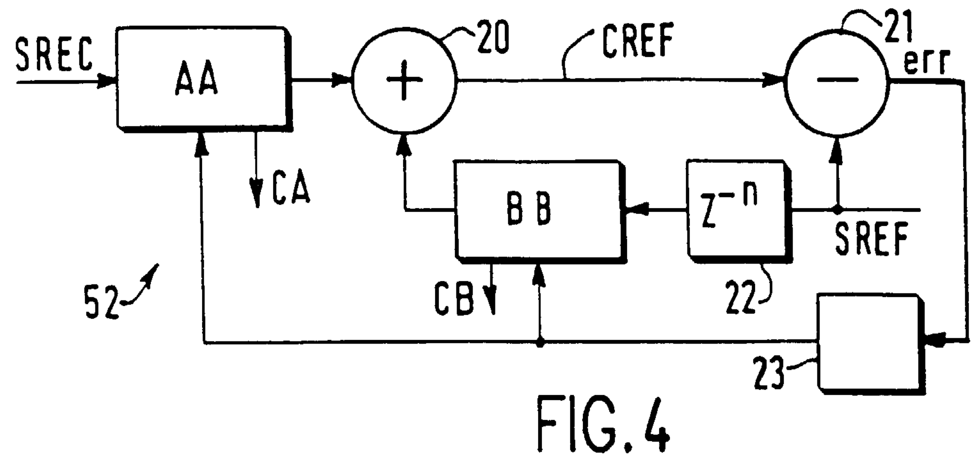


FIG. 4

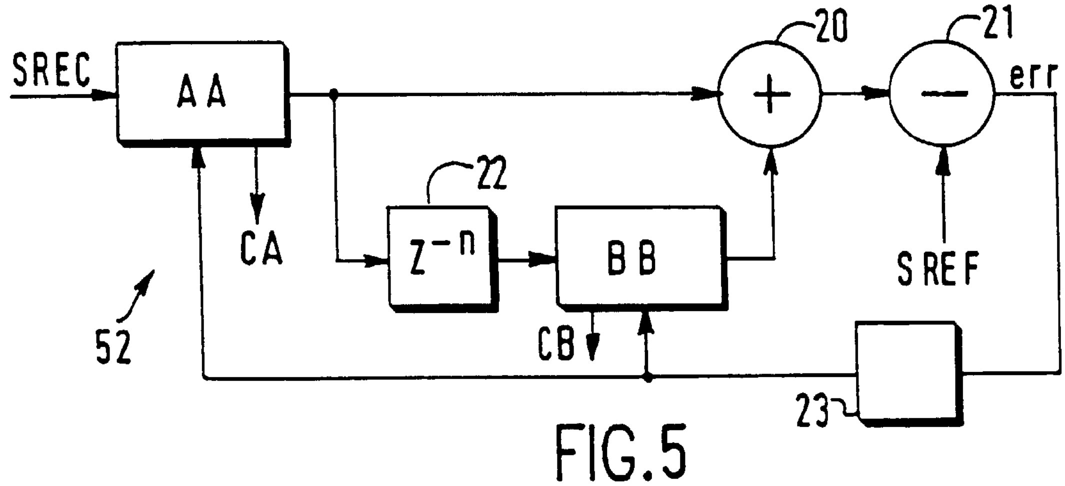


FIG. 5

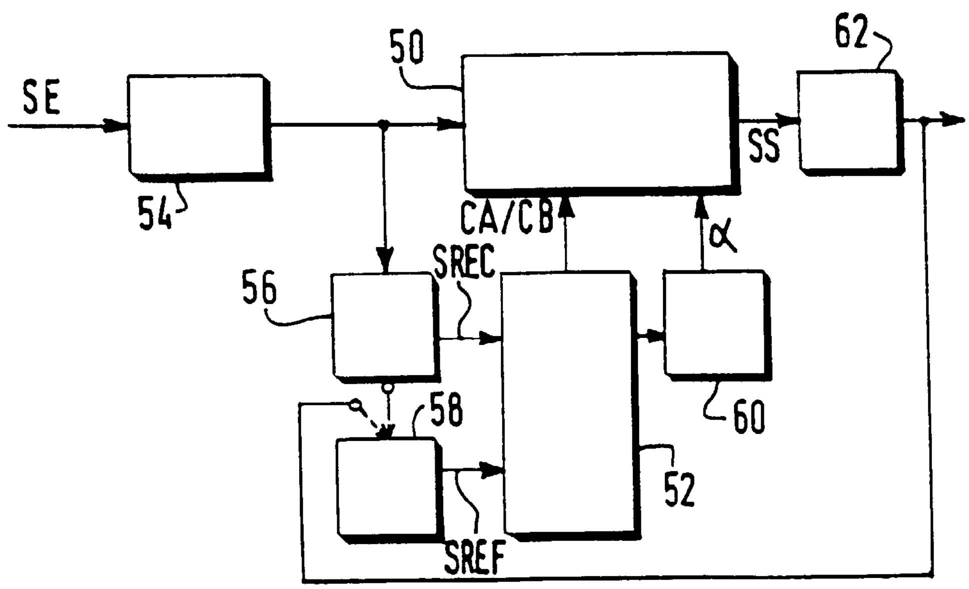


FIG. 6